# FASCICULE DE BREVET EUROPEEN

(11) **EP 4 032 120 B1**
(45) Date de publication et mention de la délivrance du brevet: **05.06.2024**
(21) Numéro de dépôt: 20771555.8
(22) Date de dépôt: 14.09.2020
(51) Int. Cl.: H01L 21/677, H01L 21/67

(54) **DISPOSITIF D'HOMOGÉNÉISATION**
HOMOGENISIERUNGSVORRICHTUNG
HOMOGENIZATION DEVICE

(30) Priorité: 20.09.2019 FR 1910383
(43) Date de publication de la demande: 27.07.2022
(73) Titulaire: ECM GREENTECH, 38800 Le Pont-De-Claix (FR)
(72) Inventeur: LORETZ, Jean-Charles, 34160 CASTRIES (FR); NGUYEN, Tich Duy, 34160 CASTRIES (FR)
(74) Mandataire: Cabinet Beaumont
(86) Numéro de dépôt international: PCT/EP2020/075670
(87) Numéro de publication internationale: WO 2021/052917

(56) Documents cités:
- FR-A1- 2 824 663
- JP-A- H04 308 087
- JP-A- 2016 163 025
- JP-U- H0 189 738

## Description

La présente demande de brevet revendique la priorité de la demande de brevet français 19/10383.

### Domaine technique

La présente description concerne de façon générale un dispositif d'homogénéisation pour une installation de traitement de pièces, notamment de plaquettes de silicium, mettant en oeuvre au moins un gaz de traitement.

### Technique antérieure

Il est connu de réaliser différents traitements de plaquettes de silicium, notamment des traitements de dopage, de diffusion, ou d'oxydation. Ces traitements comprennent généralement l'introduction des plaquettes dans un four, le maintien des plaquettes à une température de traitement et l'introduction dans le four d'au moins un gaz réactif, éventuellement mélangé à un gaz porteur. La pression dans le four peut être une pression atmosphérique ou inférieure à la pression atmosphérique.

Les fours horizontaux ou verticaux utilisés ont généralement une enceinte de forme tubulaire dans laquelle les plaquettes de silicium sont disposées sur un support. L'une des extrémités de l'enceinte est dotée d'une porte pour permettre l'introduction des plaquettes. L'autre extrémité de l'enceinte est obturée par une paroi terminale inamovible. Le gaz réactif ou les gaz réactifs sont généralement injectés au travers d'un orifice pratiqué dans la paroi terminale inamovible.

Il est souhaitable que le traitement appliqué aux plaquettes soit réalisé de façon uniforme pour l'ensemble des plaquettes introduites dans le four. Ceci implique que le flux du gaz réactif ou des gaz réactifs qui atteint chaque plaquette soit sensiblement homogène. Cette répartition uniforme peut être difficile à réaliser, en particulier pour les plaquettes les plus proches de la zone d'introduction du gaz réactif ou des gaz réactifs, notamment lorsque la pression dans l'enceinte est inférieure à la pression atmosphérique.

JP2016163025, JPH04308087 et JPH0189738U décrivent des dispositifs d'homogénéisation de l'art antérieur.

### Résumé de l'invention

Ainsi, un objet d'un mode de réalisation est de pallier au moins en partie les inconvénients des installations de traitement décrites précédemment.

Un objet d'un mode de réalisation est d'améliorer l'homogénéisation du flux gazeux qui atteint les pièces à traiter disposées dans l'installation de traitement.

Un autre objet d'un mode de réalisation est que la pression dans l'enceinte de l'installation de traitement est inférieure à la pression atmosphérique.

Dans ce but, un mode de réalisation prévoit un dispositif comprenant des première et deuxième plaques et un dispositif de maintien des plaques en vis-à-vis, la première plaque comprenant au moins dix ouvertures traversantes et la seconde plaque n'étant pas traversée par des ouvertures.

Selon un mode de réalisation, l'écart entre les deux plaques est compris entre 10 mm et 150 mm.

Selon un mode de réalisation, les première et deuxième plaques ont les mêmes dimensions.

Selon un mode de réalisation, les première et deuxième plaques sont parallèles.

Selon un mode de réalisation, chacune des première et deuxième plaques est inscrite dans un cylindre à base circulaire dont le diamètre est compris entre 200 mm et 400 mm.

Selon un mode de réalisation, le dispositif de maintien est logé en totalité entre les première et deuxième plaques.

Un mode de réalisation prévoit également une installation de dopage, de diffusion ou d'oxydation de plaquettes de silicium comprenant un four pourvu d'une enceinte adaptée à être fermée hermétiquement par une porte, dans laquelle enceinte sont introduites lesdites plaquettes, ledit four comportant au moins une tubulure d'introduction d'au moins un gaz dans l'enceinte et au moins une tubulure d'extraction du gaz, et un moyen d'aspiration connecté à ladite tubulure d'extraction configuré pour créer une dépression dans l'enceinte. L'installation comprend en outre le dispositif tel que défini précédemment, disposé entre la sortie de la tubulure d'introduction et les plaquettes, la première plaque étant orientée du côté des plaquettes et la deuxième plaque étant orientée du côté de la sortie de la tubulure d'introduction.

Selon un mode de réalisation, chaque plaquette de silicium comprend deux faces opposées reliées par un bord, et dans laquelle les plaquettes de silicium sont disposées dans l'enceinte de façon sensiblement horizontale ou verticale.

Un mode de réalisation prévoit également un procédé de dopage ou diffusion, ou oxydation de plaquettes de silicium, lesdites plaquettes étant introduites dans l'enceinte d'un four fermée hermétiquement par une porte, ledit four comportant au moins une tubulure d'introduction d'au moins un gaz dans l'enceinte et au moins une tubulure d'extraction du gaz, et un moyen d'aspiration connecté à ladite tubulure d'extraction, et créant une dépression dans l'enceinte, le dispositif tel que défini précédemment étant disposé entre la sortie de la tubulure d'introduction et les plaquettes, la première plaque étant orientée du côté des plaquettes et la deuxième plaque étant orientée du côté de la sortie de la tubulure d'introduction.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective d'un mode de réalisation d'un dispositif d'homogénéisation ;
la figure 2 est une vue en perspective d'une variante du dispositif d'homogénéisation représenté en figure 1 ;
la figure 3 est une vue de face du dispositif d'homogénéisation de la figure 2 ;
la figure 4 est une vue de côté du dispositif d'homogénéisation de la figure 2 ;
la figure 5 est une vue en coupe, partielle et schématique, d'un mode de réalisation d'une installation de traitement ;
la figure 6 est une vue en perspective plus détaillée, avec coupe partielle, d'un mode de réalisation d'une installation de traitement ;
la figure 7 est une vue de côté, avec coupe partielle, de l'installation de traitement représentée en figure 6 ;
la figure 8 est une vue de dessus, avec coupe partielle, de l'installation de traitement représentée en figure 6 ; et
la figure 9 est une vue en coupe de l'installation de traitement représentée en figure 6 selon un plan perpendiculaire à l'axe longitudinal de l'installation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les procédés de traitement de plaquettes de silicium sont bien connus et ne sont pas décrits en détail.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à une installation de traitement de plaquettes de silicium dans une position normale d'utilisation. Sauf précision contraire, les expressions "environ", "approximativement", "sensiblement", et "de l'ordre de" signifient à 10 % près, de préférence à 5 % près. Lorsque les expressions "environ", "approximativement", "sensiblement", et "de l'ordre de" sont utilisées en relation avec des directions ou des angles, elles signifient à 10 ° près, de préférence à 5 ° près.

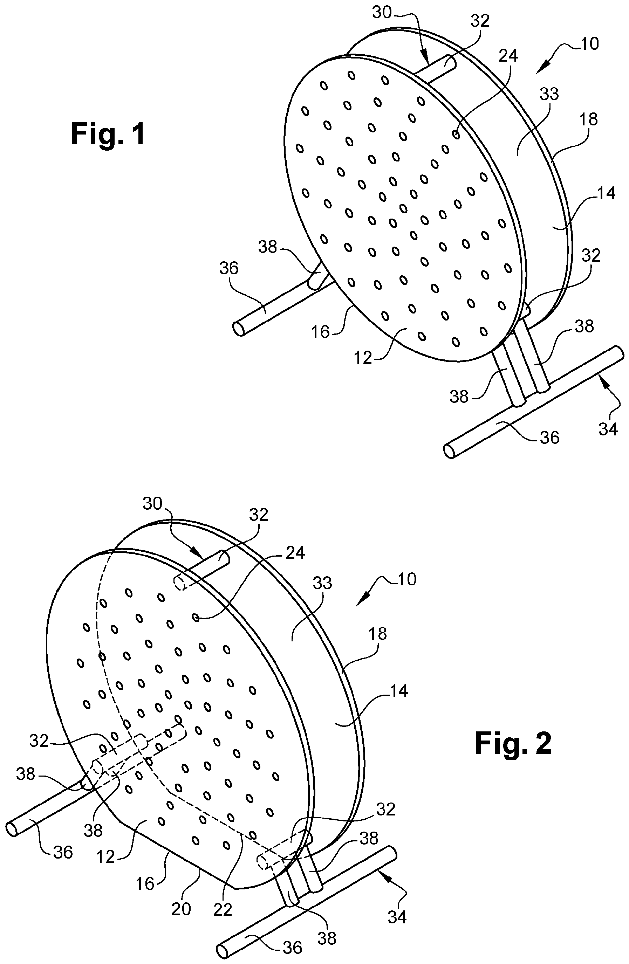

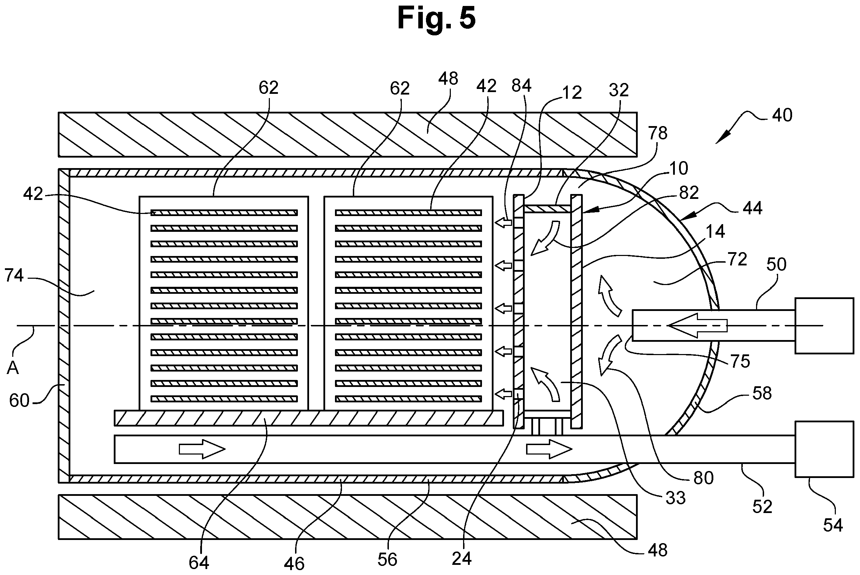

La présente invention porte sur un dispositif d'homogénéisation pour une installation de traitement de pièces, notamment de plaquettes de silicium. Un mode de réalisation du dispositif d'homogénéisation va être décrit dans un premier temps en relation avec les figures 1 à 4 et un mode de réalisation d'un procédé de traitement utilisant un tel dispositif d'homogénéisation en relation avec les figures 5 à 9.

La figure 1 est une vue en perspective, partielle et schématique, d'un mode de réalisation d'un dispositif d'homogénéisation 10. Les figures 2, 3 et 4 sont respectivement une vue en perspective avec transparence, une vue de face avec transparence et une vue de côté d'une variante avec transparence du dispositif d'homogénéisation 10.

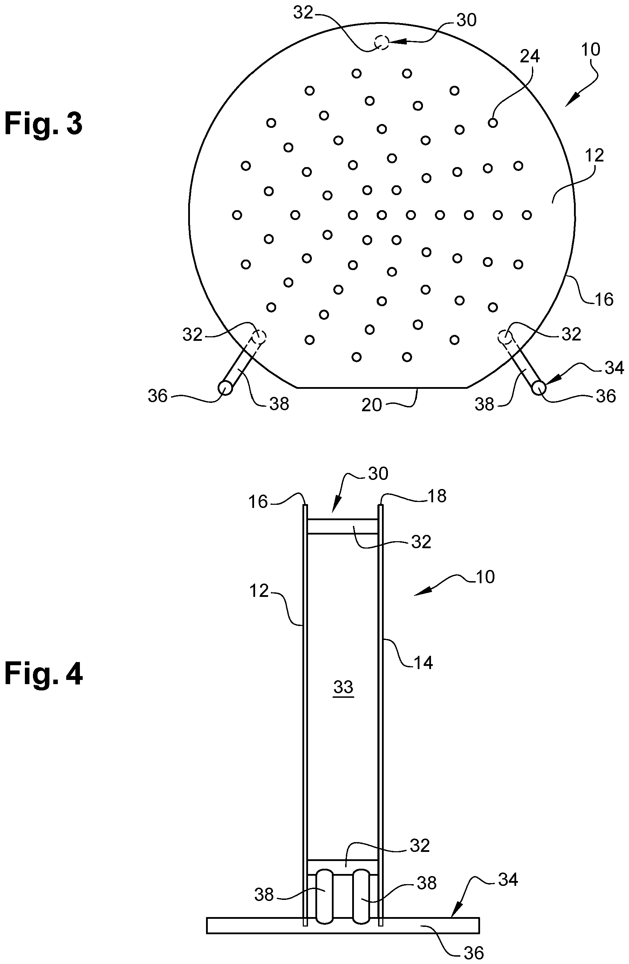

Le dispositif d'homogénéisation 10 comprend des première et deuxième plaques 12, 14. Les plaques 12, 14 sont de préférence planes. Les plaques 12, 14 sont de préférence parallèles. La plaque 12 comprend un bord externe 16 et la plaque 14 comprend un bord externe 18. Les plaques 12, 14 ont de préférence les mêmes dimensions. La forme des bords 16, 18 des plaques 12, 14 dépend notamment de la forme de l'enceinte dans laquelle le dispositif d'homogénéisation 10 est destiné à être disposé. Dans le mode de réalisation représenté en figure 1, chaque plaque 12, 14 est de forme circulaire. Dans la variante illustrée sur les figures 2 à 4, le bord 16, 18 de chaque plaque 12, 14 a une forme circulaire à l'exception d'une portion rectiligne 20, 22. L'épaisseur de chaque plaque 12, 14 est, par exemple, comprise entre 1 mm et 10 mm, par exemple égale à environ 3 mm. Chaque plaque 12, 14 peut être réalisée en quartz, en carbure de silicium, ou en silicium, et, de préférence, en quartz. Selon un mode de réalisation, chaque plaque 12, 14 est, dans la vue de face de la figure 3, inscrite dans un cercle dont le diamètre est compris entre 200 mm et 400 mm, par exemple égal à environ 300 mm.

La première plaque 12 est traversée par des ouvertures 24. La deuxième plaque 14 est pleine, c'est-à-dire qu'elle n'est traversée par aucune ouverture. Chaque ouverture 24 peut avoir une section circulaire. Selon un mode de réalisation, le diamètre de chaque ouverture 24 est compris entre 2 mm et 20 mm, par exemple égal à environ 6 mm. Le nombre d'ouvertures 24 peut varier de 30 à 300, par exemple égal à environ 60. Selon un mode de réalisation, les ouvertures 24 sont réparties de façon sensiblement uniforme sur la plaque 12. Selon un mode de réalisation, les ouvertures 24 sont réparties sur des cercles concentriques depuis le centre de la plaque 12. Le nombre d'ouvertures 24 par cercle peut être sélectionné de façon que la distance entre deux ouvertures adjacentes sur un même cercle augmente, de préférence de moins de 50 %, par rapport à la distance entre deux ouvertures adjacentes sur le cercle adjacent interne.

Selon un mode de réalisation, le dispositif d'homogénéisation 10 comprend un dispositif de liaison 30 liant rigidement la première plaque 12 à la deuxième plaque 14. Selon un mode de réalisation, le dispositif de liaison 30 est disposé en totalité entre les deux plaques 12, 14. Selon un mode de réalisation, le dispositif de liaison 30 comprend des entretoises 32 disposées entre les plaques 12, 14 et fixées aux plaques 12, 14. Le dispositif de liaison 30 maintient une zone libre 33 entre les plaques 12, 14. A titre d'exemple, sur les figures 1 à 4, on a représenté trois entretoises 32 sous la forme de tiges cylindriques d'axes parallèles et fixées aux extrémités axiales aux plaques 12, 14. Selon un mode de réalisation, l'écart entre les plaques 12, 14 est compris entre 10 mm et 60 mm, par exemple égal à environ 35 mm. A titre d'exemple, chaque tige cylindrique 32 a un diamètre compris entre 5 mm et 15 mm, par exemple égal à environ 10 mm. Les tiges 32 peuvent être réalisées avec le même matériau que les plaques 12, 14, notamment en quartz, en carbure de silicium, ou en silicium, et, de préférence, en quartz.

Selon un mode de réalisation, le dispositif d'homogénéisation 10 comprend un dispositif de support 34 des plaques 12, 14. Selon un mode de réalisation, le dispositif de support 34 comprend deux pieds 36 destinés à reposer sur l'enceinte dans laquelle le dispositif d'homogénéisation 10 est disposé en fonctionnement. Selon un mode de réalisation, les pieds 36 correspondent à des tiges d'axes parallèles. La longueur de chaque tige 36 peut être comprise entre 100 mm et 300 mm, par exemple égale à environ 180 mm. A titre d'exemple, chaque pied 36 a un diamètre compris entre 5 mm et 15 mm, par exemple égal à environ 10 mm. Chaque pied 36 est relié à l'une des entretoises 32 par deux tiges 38. Les pieds 36 et les tiges 38 peuvent être réalisés avec le même matériau que les plaques 12, 14, notamment en quartz, en carbure de silicium, ou en silicium, et, de préférence, en quartz.

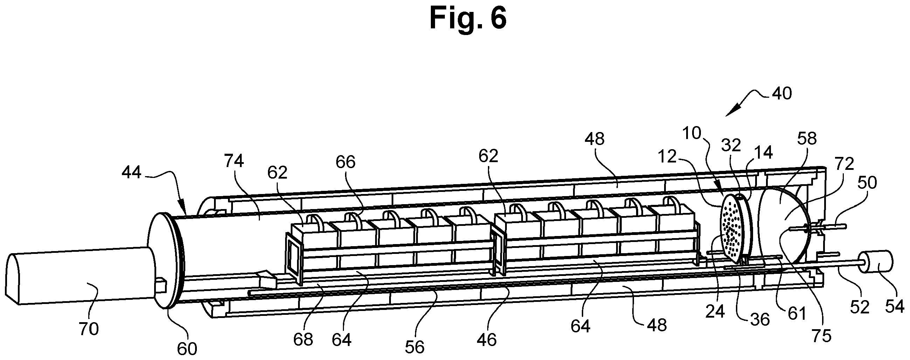

La figure 5 est une vue en coupe, partielle et schématique d'un mode de réalisation d'une installation de traitement 40 comprenant le dispositif d'homogénéisation 10. Les figures 6 à 9 représentent un mode de réalisation plus détaillé de l'installation de traitement 40.

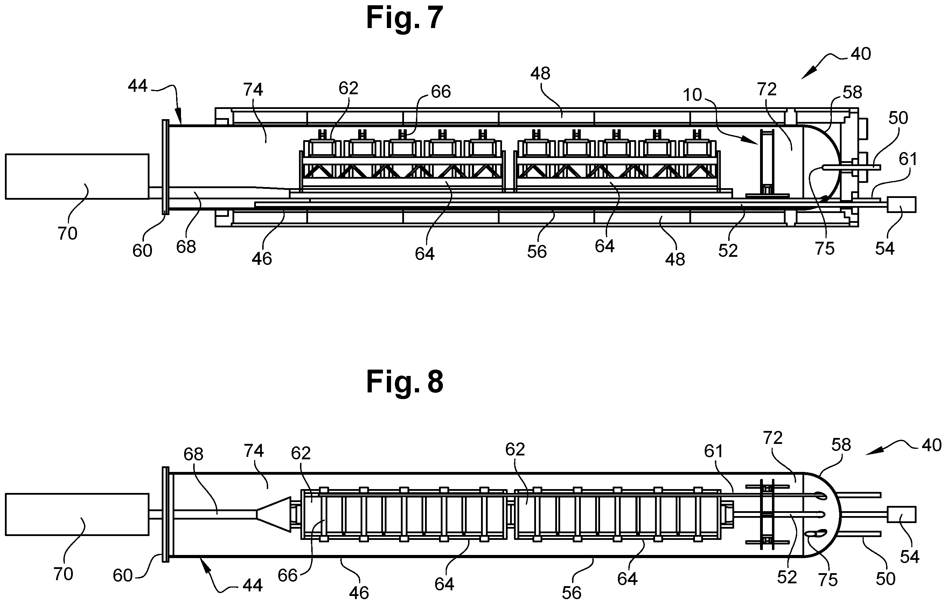

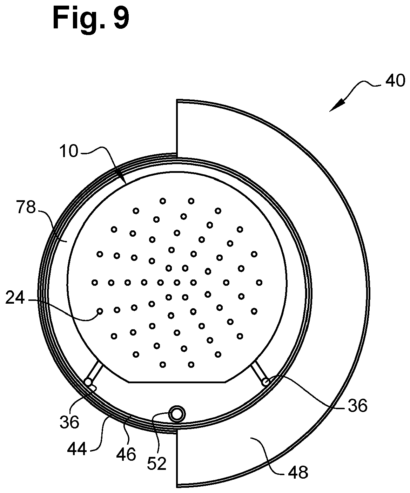

L'installation de traitement 40, notamment pour le dopage, la diffusion ou l'oxydation de plaquettes de silicium 42, comprend un four 44 doté d'une enceinte étanche 46 d'axe A associée à des moyens de chauffage 48, et dans laquelle sont introduites les plaquettes de silicium 42 devant subir l'une des opérations précitées. Les moyens de chauffage 48 ne sont pas représentés en figure 8 et seulement partiellement représentés en figure 9. Selon un mode de réalisation, l'axe A est sensiblement horizontal. Le plan de coupe de la figure 5 est alors le plan vertical comprenant l'axe A.

Le four 44 comporte au moins une tubulure d'introduction 50, d'au moins un gaz dans l'enceinte 46 pour accomplir les opérations de traitement souhaitées. Le four 44 comprend en outre au moins une tubulure 52 d'extraction du gaz, et un moyen d'aspiration 54 connecté à ladite tubulure 52 d'extraction du gaz, configuré pour créer dans l'enceinte une dépression constante et contrôlée, ce moyen d'aspiration 54 pouvant être situé à distance du four 44 dans une zone tempérée. Le moyen d'extraction 54 peut comprendre une pompe aspirante. Selon un mode de réalisation, la pression moyenne dans l'enceinte 46 peut être comprise entre 100 Pa (1 millibar) et 90000 Pa (900 millibars).

L'enceinte 46 a par exemple un corps central 56 de forme tubulaire d'axe A. De préférence, le corps central 56 présente une section droite en forme de couronne circulaire. Cette disposition confère à la paroi de l'enceinte 46 une bonne résistance mécanique à la pression atmosphérique lorsque le volume interne de l'enceinte est soumis à dépression. Selon un mode de réalisation, l'enceinte 46 est fermée hermétiquement à une extrémité, selon l'axe A, par une paroi terminale fixe 58. La paroi terminale 58 peut avoir une forme hémisphérique. L'enceinte 46 est fermée, à l'extrémité selon l'axe A opposée à la paroi terminale 58, par une porte 60, mobile entre une position de fermeture, représentée sur les figures, et une position d'ouverture. L'enceinte 46 est sensiblement étanche au gaz lorsque la porte 60 est dans la position de fermeture.

Les moyens de chauffage 48 comprennent par exemple des résistances électriques, par exemple réparties ou enroulées autour de l'enceinte tubulaire 46 et disposées à écartement de cette dernière ou bien à son contact. Pour résister à la chaleur, la paroi tubulaire de l'enceinte 46, la paroi terminale 58 et la porte 60 peuvent être réalisées en quartz. L'enceinte 46 peut être équipée d'une chemise interne en carbure de silicium. Les mouvements de fermeture et d'ouverture de la porte 60 s'effectuent selon l'axe longitudinal A de l'enceinte tubulaire 46. Le four 44 peut comprendre des capteurs de température, non représentés, par exemple disposés sur une tige 61 en quartz représentée sur les figures 6 à 7.

Dans le présent mode de réalisation, les plaquettes 42 sont disposées sensiblement horizontalement dans l'enceinte 46. Selon un mode de réalisation, les plaquettes de silicium 42 sont disposées sur un casier 62, les plaquettes de silicium 42 étant empilées selon la verticale dans le casier 62, un interstice pour le passage de gaz étant maintenu entre chaque paire de plaquettes adjacentes 42. Les casiers 62 peuvent être réalisés en carbure de silicium ou bien en quartz. Plusieurs casiers 62 chargés de plaquettes 42 peuvent être disposés l'un derrière l'autre simultanément dans l'enceinte 46. Selon un mode de réalisation, plusieurs casiers 62 chargés de plaquettes 42 peuvent être disposés l'un derrière l'autre sur un charriot mobile 64 qui peut être introduit dans l'enceinte 46 ou extrait de l'enceinte 46. Selon un mode de réalisation, au moins deux chariots 64 peuvent être disposés simultanément dans l'enceinte 46. Sur la figure 5, on a représenté un chariot 64 portant deux casiers 62 chargés de plaquettes 42 dans l'enceinte 46 et sur les figures 6 à 8, on a représenté deux chariots 64 l'un derrière l'autre portant chacun cinq casiers 62 chargés de plaquettes 42 dans l'enceinte 46. Chaque casier 62 peut comprendre une poignée 66, représentée seulement sur les figures 6 à 8, pouvant être saisie par un bras manipulateur, non représenté, disposé à l'extérieur de l'installation de traitement 40 et permettant de placer le casier 62 sur le chariot 64 ou de retirer le casier 62 du chariot 64.

Selon un mode de réalisation, le déplacement des chariots 64 peut être réalisé par des moyens d'actionnement comprenant notamment une poutre 68 coopérant avec les chariots 64 et déplacée selon l'axe longitudinal de l'enceinte 46 par un moteur 70. Le déplacement de la porte 60 peut être réalisé simultanément avec le déplacement de la poutre 68.

Les casiers 62 portant les plaquettes 42, après positionnement dans l'enceinte 46, sont disposés à écartement de la paroi terminale 58 et de la porte 60, ce qui ménage une zone amont 72 située entre la paroi terminale 58 et les casiers 62, et une zone aval 74 située entre la porte 60 et les casiers 62. Le trajet des gaz dans l'enceinte 46 s'établit depuis une zone amont 72 vers une zone aval 74 située à distance de la précédente, les plaquettes de silicium 42 étant disposées entre ces deux zones sur le trajet des gaz. Ces plaquettes 42 sont disposées dans l'enceinte 46 du four de manière transversale à la direction d'écoulement des gaz dans cette dernière. Ainsi est créée une perte de charge grâce à laquelle les gaz peuvent venir balayer les surfaces à traiter des plaquettes 42.

La ou les tubulures d'introduction 50 du ou des gaz dans l'enceinte 46 du four traversent de part en part la paroi terminale 58 de ce dernier et débouchent dans la zone amont 72 et la tubulure d'extraction 52 des gaz traverse de part en part la paroi terminale 58, s'étend dans l'enceinte 46 et débouche dans la zone aval 74. L'installation 40 peut comprendre des organes de contrôle et de régulation de la dépression créée dans l'enceinte 46 du four. Les organes de contrôle peuvent comprendre des vannes, non représentées, prévues sur la ou les tubulures d'introduction 50 et/ou sur la tubulure d'extraction 52.

Le dispositif d'homogénéisation 10 est disposé dans l'enceinte 46 dans la zone amont 72 et est interposé entre la sortie 75 de la ou les tubulures d'introduction 50 et les casiers 62. La plaque 12 comprenant les ouvertures 24 est orientée du côté des casiers 62 tandis que la plaque 14 pleine est orientée du côté de la sortie 75 de la ou les tubulures d'introduction 50. Le dispositif d'homogénéisation 10 repose sur la paroi interne de l'enceinte 46. Les dimensions des plaques 12, 14 sont telles qu'un passage 78 est présent entre le bord externe de la plaque 14 et l'enceinte 46 comme cela est représenté sur les figures 5 et 9.

Selon un mode de réalisation, la plaque 14 permet de couper le flux de gaz introduit par la ou les tubulures d'introduction 50. Ceci entraîne la formation de turbulences, ce qui illustré par les flèches 80 en figure 5, qui augmente la durée de résidence des gaz dans la zone amont 72. Ceci permet d'améliorer le chauffage et le mélange des gaz réactifs. Les gaz contournent la plaque 14 par le passage 78 et au moins une partie des gaz se répartissent dans la zone libre 33 entre les plaques 12 et 14, ce qui illustré par les flèches 82 en figure 5, et traversent la plaque 12 par les ouvertures 24, ce qui illustré par les flèches 84 en figure 5. Ceci permet d'améliorer l'homogénéité du flux de gaz qui atteint les plaquettes 42 selon l'axe longitudinal A de l'enceinte 46, notamment les plaquettes 42 les plus proches du dispositif d'homogénéisation 10. Ceci permet d'améliorer l'uniformité du traitement réalisé sur les plaquettes 42. De façon avantageuse, les faces principales de chaque plaquette 42 sont sensiblement parallèles au flux de gaz dans l'enceinte 46.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que dans les modes de réalisation décrits, les gaz s'écoulent de la zone amont 72 vers la zone aval 74, il est clair que le trajet des gaz dans l'enceinte 46 peut être réalisé de la zone aval 74 vers la zone amont 72, la tubulure d'introduction 50 débouchant alors dans la zone aval 74 et la tubulure d'extraction 52 débouchant dans la zone amont 72. En outre, bien que dans les modes de réalisation décrits précédemment, l'axe longitudinal A de l'enceinte 46 est sensiblement horizontal, l'axe longitudinal A de l'enceinte 46 pourrait être orienté différemment, et être, par exemple, sensiblement vertical. De plus, bien que dans les modes de réalisation décrits précédemment, les plaquettes 42 de silicium sont disposées de façon sensiblement horizontale dans l'enceinte 46, la disposition des plaquettes de silicium 42 peut être différente. A titre d'exemple, les plaquettes 42 peuvent être disposées de façon sensiblement verticale dans l'enceinte.

Enfin, la mise en oeuvre pratique des modes de réalisation et variantes décrits est à la portée de l'homme du métier à partir des indications fonctionnelles données ci-dessus. L'invention est définie par les revendications.

## Revendications

1. Dispositif comprenant des première et deuxième plaques (12, 14), un dispositif de maintien (30) des plaques en vis-à-vis et un dispositif de support (34) des première et deuxième plaques, la première plaque (12) comprenant au moins dix ouvertures traversantes (24) et la seconde plaque n'étant pas traversée par des ouvertures, le dispositif de maintien (30) comprenant des entretoises (32) disposées entre les première et deuxième plaques et fixées aux première et deuxième plaques, et le dispositif de support (34) comprenant deux pieds (36) correspondant à des première tiges d'axes parallèle, le dispositif comprenant en outre des deuxièmes tiges (38)tel que chaque pied est relié à l'une des entretoises par deux deuxièmes tiges (38).

2. Dispositif selon la revendication 1, dans lequel l'écart entre les deux plaques est compris entre 10 mm et 50 mm.

3. Dispositif selon la revendication 1 ou 2, dans lequel les première et deuxième plaques (12, 14) ont les mêmes dimensions.

4. Dispositif selon l'une quelconque des revendications 1 à 3, dans lequel les première et deuxième plaques (12, 14) sont parallèles.

5. Dispositif selon l'une quelconque des revendications 1 à 4, dans lequel chacune des première et deuxième plaques (12, 14) est inscrite dans un cylindre à base circulaire dont le diamètre est compris entre 200 mm et 400 mm.

6. Dispositif selon l'une quelconque des revendications 1 à 4, dans lequel le dispositif de maintien (30) est logé en totalité entre les première et deuxième plaques (12, 14).

7. Installation de dopage, de diffusion ou d'oxydation de plaquettes de silicium (42) comprenant un four (44) pourvu d'une enceinte (46) adaptée à être fermée hermétiquement par une porte (60), dans laquelle enceinte sont introduites lesdites plaquettes, ledit four comportant au moins une tubulure (50) d'introduction d'au moins un gaz dans l'enceinte (46) et au moins une tubulure (52) d'extraction du gaz, et un moyen d'aspiration (54) connecté à ladite tubulure d'extraction (52) configuré pour créer une dépression dans l'enceinte (46), l'installation comprenant en outre le dispositif selon l'une quelconque des revendications 1 à 6, disposé entre la sortie (75) de la tubulure d'introduction (50) et les plaquettes, la première plaque (12) étant orientée du côté des plaquettes et la deuxième plaque (14) étant orientée du côté de la sortie de la tubulure d'introduction (50).

8. Procédé de dopage ou diffusion, ou oxydation de plaquettes de silicium (4), lesdites plaquettes étant introduites dans l'enceinte d'un four (44) fermée hermétiquement par une porte (60), ledit four comportant au moins une tubulure (50) d'introduction d'au moins un gaz dans l'enceinte (46) et au moins une tubulure (52) d'extraction du gaz, et un moyen d'aspiration (54) connecté à ladite tubulure d'extraction (52), et créant une dépression dans l'enceinte (46), le dispositif selon l'une quelconque des revendications 1 à 6 étant disposé entre la sortie (75) de la tubulure d'introduction (50) et les plaquettes, la première plaque (12) étant orientée du côté des plaquettes et la deuxième plaque (14) étant orientée du côté de la sortie de la tubulure d'introduction (50).

## Patentansprüche

1. Vorrichtung aufweisend eine erste und eine zweite Platte (12, 14), eine Haltevorrichtung (30) zum gegenüberliegenden Halten der Platten und eine Tragvorrichtung zum Tragen (24) der ersten und der zweiten Platte, wobei die erste Platte (12) wenigstens zehn Durchgangsöffnungen (24) aufweist und die zweite Platte nicht von Öffnungen durchquert wird, wobei die Haltevorrichtung (30) Abstandshalter (32) aufweist, die zwischen der ersten und der zweiten Platte angeordnet und an der ersten und der zweiten Platte befestigt sind, und wobei die Tragvorrichtung (34) zwei Füße (36) aufweist, die ersten Stangen mit parallelen Achsen entsprechen, wobei die Vorrichtung ferner zweite Stangen (38) aufweist wobei jeder Fuß durch zwei der zweiten Stangen (38) mit einem der Abstandshalter verbunden ist.

2. Vorrichtung nach Anspruch 1, wobei der Abstand zwischen den beiden Platten im Bereich von 10 mm bis 50 mm liegt.

3. Vorrichtung nach Anspruch 1, bei der die erste und die zweite Platte (12, 14) die gleichen Abmessungen haben.

4. Vorrichtung nach Anspruch 1, wobei die erste und die zweite Platte (12, 14) parallel sind.

5. Vorrichtung nach Anspruch 1, wobei die erste und die zweite Platte (12, 14) jeweils in einen Zylinder mit kreisförmiger Grundfläche und einem Durchmesser im Bereich von 200 mm bis 400 mm eingeschrieben sind.

6. Vorrichtung nach Anspruch 1, wobei die Haltevorrichtung (30) vollständig zwischen der ersten und der zweiten Platte (12, 14) untergebracht ist.

7. Anlage (42) zum Dotieren, Diffundieren oder Oxidieren von Siliziumwafern, aufweisend einen Ofen (44), der mit einem durch eine Tür (60) hermetisch verschließbaren Gehäuse (46) versehen ist, in das die Scheiben eingeführt werden, wobei der Ofen mindestens eine Einlassleitung (50) zum Einlassen mindestens eines Gases in das Gehäuse (46) und mindestens eine Gasabzugsleitung (52) aufweist, sowie Absaugmittel (54), die mit der Absaugleitung (52) verbunden sind, die konfiguriert sind zum Erzeugen eines Unterdrucks in dem Gehäuse (46), wobei die Anlage ferner die Vorrichtung nach Anspruch 1 aufweist, die zwischen dem Auslass (75) der Einlassleitung (50) und den Wafern angeordnet ist, wobei die erste Platte (12) zu den Wafern weist und die zweite Platte (14) zum Auslass der Einlassleitung (50) weist.

8. Verfahren zum Dotieren, Diffundieren oder Oxidieren von Siliziumwafern (4), wobei die Wafer in das Gehäuse eines Ofens (44) eingeführt sind, das durch eine Tür (60) hermetisch verschlossen ist, wobei der Ofen mindestens eine Einlassleitung (50) zum Einlassen mindestens eines Gases in das Gehäuse (46), mindestens eine Gasabzugsleitung (52), und Absaugmittel (54) aufweist, die mit der Absaugleitung (52) verbunden sind und einen Unterdruck in dem Gehäuse (46) erzeugen, wobei die Vorrichtung nach einem der Ansprüche 1 bis 6 zwischen dem Ausgang (75) der Einlassleitung (50) und den Wafern angeordnet ist, wobei die erste Platte (12) zu den Wafern weist und die zweite Platte (14) zum Ausgang der Einlassleitung (50) weist.

## Claims

1. A device comprising first and second plates (12, 14), a device (30) for holding the plates face to face and a device for supporting (24) the first and second plates, wherein the first plate (12) comprises at least ten through openings (24) and the second plate is not crossed by openings, the holding device (30) comprising spacers (32) arranged between the first and second plates and attached to the first and second plates, and the supporting device (34) comprising two feet (36) corresponding to first rods having parallel axes, the device further comprising second rods (38), wherein each foot is linked to one of the spacers by two second rods (38).

2. The device according to claim 1, wherein the interval between the two plates is in the range from 10 mm to 50 mm.

3. The device according to claim 1, wherein the first and second plates (12, 14) have the same dimensions.

4. The device according to claim 1, wherein the first and second plates (12, 14) are parallel.

5. The device according to claim 1, wherein each of the first and second plates (12, 14) is inscribed within a cylinder having a circular base with a diameter in the range from 200 mm to 400 mm.

6. The device according to claim 1, wherein the holding device (30) is totally housed between the first and second plates (12, 14).

7. A silicon wafer doping, diffusion, or oxidation installation (42) comprising a furnace (44) provided with an enclosure (46) capable of being tightly closed by a door (60), in which enclosure said wafers are introduced, said furnace comprising at least one pipe (50) for letting at least one gas into the enclosure (46) and at least one gas extraction pipe (52), and suction means (54) connected to said extraction pipe (52) configured to create a depression in the enclosure (46), the installation further comprising the device according to claim 1, arranged between the outlet (75) of the inlet pipe (50) and the wafers, the first plate (12) facing the wafers and the second plate (14) facing the outlet of the inlet pipe (50).

8. A method of doping or diffusion, or oxidation of silicon wafers (4), said wafers being introduced into the enclosure of a furnace (44) tightly closed by a door (60), said furnace comprising at least one pipe (50) for letting at least one gas into the enclosure (46) and at least one gas extraction pipe (52), and suction means (54) connected to said extraction pipe (52), and creating a depression in the enclosure (46), the device according to any of claims 1 to 6 being arranged between the outlet (75) of the inlet pipe (50) and the wafers, the first plate (12) facing the wafers and the second plate (14) facing the outlet of the inlet pipe (50).
